# EUROPEAN PATENT SPECIFICATION

(11) **EP 1 524 893 B1**
(45) Date of publication and mention of the grant of the patent: **21.04.2010**
(21) Application number: 04023145.8
(22) Date of filing: 29.09.2004
(51) Int. Cl.: H05K 7/20, H05K 3/36, H01L 25/16

(54) **Electronic control unit, in particular for motor vehicles, with improved heat dissipation system**
Elekronische Steuereinheit mit einem verbesserten Wärmeabfuhrsystem, inbesondere für Kraftfahrzeuge
Unité de contrôle électronique avec un systéme amélioré pour dissiper la chaleur, notamment dans les véhicules à moteur

(30) Priority: 03.10.2003 IT TO20030777
(43) Date of publication of application: 20.04.2005
(73) Proprietor: C.R.F. Società Consortile per Azioni, 10043 Orbassano (TO) (IT)
(72) Inventor: Faggioli, Eugenio, 10123 Torino (IT); Groppo, Riccardo, 10043 Orbassano (Torino) (IT)
(74) Representative: Quinterno, Giuseppe

(56) References cited:
- EP-A- 0 350 593
- DE-U- 9 112 371
- US-A- 4 858 074
- US-A- 5 801 330
- US-A1- 2003 198 022
- US-B1- 6 421 244

## Description

The present invention relates to an electronic control unit, in particular for use in motor vehicles.

Document US-B1-6 421 244 discloses a relating art.

One object of the invention is to propose an electronic control unit with features aimed at improving the dissipation of the heat generated by its components during operation.

This object and other objects are achieved according to the invention by an electronic control unit comprising:
a container made of metallic material with a base plate or wall able to act as a heat dissipator;
a printed-circuit motherboard, mounted facing and at a predefined distance from said base plate or wall and housing a plurality of electric/electronic components or devices of the control unit;
an intermediate support unit, including a support plate arranged between the motherboard and said base plate or wall and housing one or more electronic power components or devices of said control unit; and
mechanical and electrical coupling means arranged between said support plate of the intermediate structure and the motherboard and comprising electrically conducting and mechanically resilient members, able to act as elements providing an electric connection between devices of the motherboard and devices of the intermediate structure, and as spring-loaded elements tending to push said intermediate structure towards the base plate or wall.

Further characteristic features and advantages of the invention will appear from the detailed description which follows, provided purely by way of a non-limiting example with reference to the accompanying drawings, in which:
Figure 1 is a partial sectioned view of a first electronic control unit according to the invention;
Figure 2 is a partial sectioned view of a second electronic control unit according to the invention; and

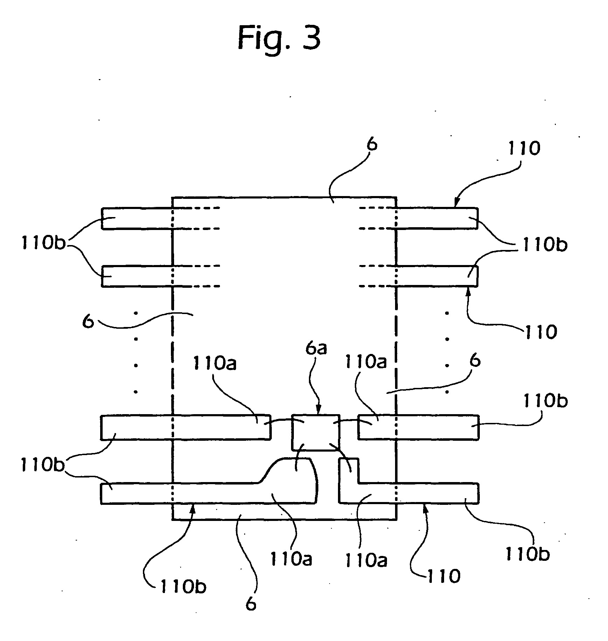

Figure 3 shows a partial plan view of a support plate provided with rheophores curved in the form of gull wings, included within the embodiment shown in Figure 2.

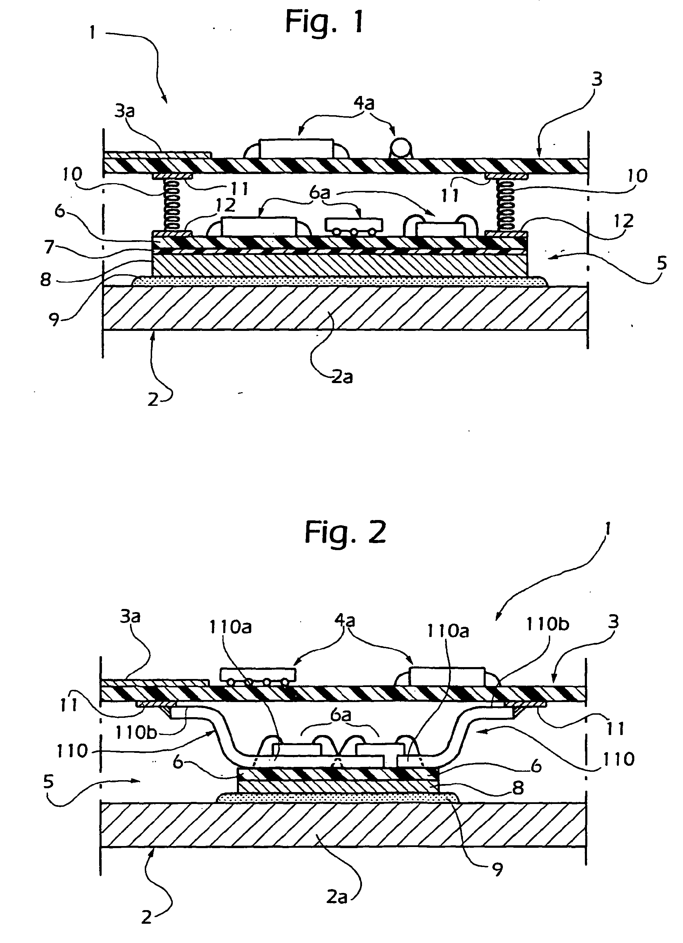

In Figures 1 and 2, 1 denotes overall a control unit designed in accordance with the present invention.

In the embodiment according to Figure 1, the control unit 1 comprises a container made of metallic material 2, for example aluminium or alloys thereof. This container may have generally a form for example similar to that of a tray. Figure 1 shows only a portion of its base plate or wall 2a, which - as will appear more clearly below - is intended to act (also) as a heat dissipator.

The control unit 1 also comprises (at least) one printed-circuit motherboard, denoted in its entirety by 3. In a manner known per se, this motherboard is mounted facing and at a predefined distance from the base plate or wall 2a of the container 2.

The motherboard 3 is made using a dielectric material and on one or both of its sides it has interconnecting and linking conductive paths 3a as well as a plurality of electric/electronic components or devices such as those indicated by 4a in Figure 1.

In the embodiment shown in Figure 1, the electronic control unit 1 also comprises an intermediate load-bearing structure denoted overall by 5 and arranged between the motherboard 3 and the base plate or wall 2a.

The intermediate structure 5 includes a printed-circuit support plate 6, housing electronic power components or devices indicated by 6a. These components may be fixed to the support plate 6 using various methods known per se, for example the methods known as SMT (Surface Mounting Technology), BGA (Ball Grid Array), wire-bonding or other methods.

The components 6a are mounted on the plate 6 on the side thereof facing the motherboard 3.

7 denotes a thin layer of electrically and thermally insulating material arranged between the other side of the support plate 6 and an underlying sheet 8 which is relatively thicker and consists of a material which is a good heat conductor, for example copper or alloys thereof.

The sheet 8 rests on the base plate or wall 2a, with a layer of thermally conductive gel 9 arranged in between.

This gel is in particular a phase transition gel having a transition temperature in the region of the working temperature envisaged for the base plate or wall 2a, for example between 60° and 80°C.

Mechanical and electrical coupling means are arranged between the intermediate structure 5 and the motherboard 3, said means in the embodiment according to Figure 1 comprising a plurality of metal spring members 10 which are for example gold-plated and extend between conductor pads or terminals 11 provided on the bottom side of the motherboard 3 and corresponding metal connecting pads or terminals 12 provided on the upper side of the plate 6 of the intermediate structure.

The arrangement of the spring connecting members 10 is such that they act both as electrical connecting elements or rheophores, between devices of the motherboard 3 and devices of the intermediate structure 5, and as spring-loaded elements, which tend to push resiliently the intermediate structure 5 towards and against the base plate or wall 2a.

During operation, when the working temperature exceeds the phase transition temperature of the gel 9, the latter starts to become essentially liquid and penetrates into the microscopic recesses on the surface of the sheet 8 and the base plate 2a, eliminating the irregularities thereof. The surfaces of said plate 2a and the sheet 8 facing each other therefore do not require special smoothing treatment or other surface-machining operations.

The sheet 7 provides the intermediate load-bearing structure 5 with a certain mechanical and geometric stability and at the same time ensures the desired thermal capacity.

The resilient connecting elements 10 help ensure a good thermal contact between the sheet 8 of the intermediate structure and the base plate 2a and compensate for any play due to expansion or relative movements, for example as a result of vibrations.

Figure 2 shows a second embodiment of a unit according to the invention. In this figure, parts and elements which are identical or substantially equivalent to those already described above have been assigned the same reference numbers as before.

In this embodiment the intermediate structure 5 comprises a support plate 6 which is made of dielectric material, for example alumina, and on its side facing the motherboard 3 houses a plurality of electronic components or devices 6a.

First ends 110a of electrical connection terminals 110, which are essentially in the form of strips of metallic material, are fastened in a manner known per se to the upper side of the plate 6. The components 6a mounted on the plate 6 are connected using methods which are known per se, for example wire-bonding technology, to the ends 110a of terminals 110 of this plate.

As can be seen more clearly in Figure 2, the terminals 110 are curved inwards so that they have a general configuration essentially in the form of an S and their other or second ends 110b press against the bottom side of the motherboard 3 where they are welded to connecting terminals 11 of said motherboard.

Conveniently, the arrangement is such that the terminals 110 are interconnected between the plate 6 and the motherboard 3 in a spring-loaded condition so that they tend to push the intermediate structure 5 towards and against the base plate or wall 2a.

In the solution according to Figure 2 also, a sheet 8 of material which is a good heat conductor, for example copper, is provided underneath the plate 6 of the intermediate structure 5.

Conveniently, although not necessarily, the assembly formed by the terminals 10, the plate 6 and the sheet 8 is formed as a sandwich of the so-called DBC (Direct-Bonded Copper) type.

A layer of phase transition gel 9 is in any case arranged between the sheet 8 and the base plate or wall 2a, as described above with reference to the embodiment according to Figure 1.

Obviously, without modifying the principle of the invention, the embodiments and constructional details may be varied greatly with respect to those described and illustrated purely by way of a non-limiting example, without thereby departing from the scope of the invention, as defined in the accompanying claims.

## Claims

1. Electronic control unit (1), in particular for motor vehicles, comprising:
- a container (2) made of metallic material, with a base plate or wall (2a) able to act as a heat dissipator;
- a printed-circuit motherboard (3), mounted facing and at a predefined distance from said base plate or wall (2a) and housing a plurality of electric/electronic components or devices (4a) of the control unit;
- an intermediate load-bearing structure (5) including a support plate (6) arranged between the motherboard (3) and said base plate or wall (2a) and housing one or more electronic power components or devices (6a) of said control unit; and
- mechanical and electrical coupling means (10; 110) arranged between said support plate (6) of the intermediate structure (5) and the motherboard (3) and comprising electrically conducting and mechanically resilient members (10; 110), able to act as elements providing an electric connection between devices (4a) of the motherboard (3) and devices (6a) of the intermediate structure (5), and as spring-loaded elements tending to push said intermediate structure (5) towards the base plate or wall (2a).

2. Electronic control unit according to Claim 1, also comprising thermal and mechanical coupling means (8, 9) arranged between the support plate (6) of the intermediate structure (5) and the base plate or wall (2a).

3. Electronic control unit according to Claim 1 or 2, in which the support plate (6) of the intermediate structure (5) is a plate with printed circuits which on the side facing the motherboard (3) houses the abovementioned power components or devices (6a) as well as conductor terminals (12) connected to corresponding conductor terminals (11) of the motherboard (3) by means of spring members (10) made of metallic material.

4. Electronic control unit according to Claim 1 or 2, in which the support plate (6) of the intermediate structure is a plate which is made of dielectric material, preferably alumina, one side of which, on two opposite flanks, has fixed thereto first ends (110a) of respective connection terminals (110) made of metallic material and curved inwards in a general configuration essentially in the form of an S; the other or second ends (110b) of said connection terminals (110) being welded to connection terminals (11) of the motherboard (3) in a spring-loaded condition.

5. Electronic unit according to Claim 2, in which said mechanical and electric coupling means comprise:
a plate (8) which is made of thermally conductive material, preferably copper or alloys thereof, and is arranged in contact with the side of the support plate (6) of the intermediate structure (5) facing the opposite direction to the motherboard (3); and
a layer of thermally conductive gel (9) having a phase transition temperature in the region of the envisaged working temperature of said base plate or wall (2a), said layer of gel (9) being arranged between the abovementioned conductor plate (8) and the base plate or part (2a).

6. Electronic control unit according to Claims 3 and 5, in which a thin layer (7) of electrically and thermally insulating material is arranged between said printed-circuit support plate (6) and the abovementioned heat-conducting plate (8).

## Patentansprüche

1. Elektronische Steuereinheit (1) insbesondere für Kraftfahrzeuge, enthaltend:
- einen Behälter (2), bestehend aus einem Metallmaterial, mit einer Bodenplatte oder -wand (2a), die als Wärmeabbaueinrichtung wirken kann;
- eine Druckschaltkartenhauptplatine (3), die der Bodenplatte oder -wand (2a) zugewandt und in einem vorbestimmten Abstand von dieser angeordnet ist und eine Vielzahl von elektrischen/elektronischen Bauteilen oder Vorrichtungen (4a) der Steuereinheit aufnimmt;
- einen lastaufnehmende Zwischenaufbau (5), der eine Trägerplatte (6) enthält, die zwischen der Hauptplatine (3) und der Bodenplatte oder-wand (2a) angeordnet ist und eine oder mehrere elektronische Leistungskomponenten oder - vorrichtungen (6a) der Steuereinheit aufnimmt; und
- mechanische sowie elektrische Verbindungseinrichtungen (10; 110), die zwischen der Trägerplatte (6) des Zwischenaufbaus (5) und der Hauptplatine (3) angeordnet sind und elektrisch leitfähige sowie mechanisch elastische Elemente (10; 110) enthalten, die in der Lage sind, sich als Elemente, die eine elektrische Verbindung zwischen Vorrichtungen (4a) der Hauptplatine (3) und Vorrichtungen (6a) des Zwischenaufbaus (5) herstellen, und als federgespannte Elemente zu verhalten, die dazu neigen, den Zwischenaufbau (5) zur Bodenplatte oder -wand (2a) zu drücken.

2. Elektronische Steuereinheit nach Anspruch 1, weiterhin enthaltend thermische und mechanische Verbindungseinrichtungen (8, 9), die zwischen der Trägerplatte (6) des Zwischenaufbaus (5) und der Bodenplatte oder-wand (2a) angeordnet sind.

3. Elektronische Steuereinheit nach Anspruch 1 oder 2, bei der die Trägerplatte (6) des Zwischenaufbaus (5) eine Platte mit gedruckten Schaltkreisen ist, die auf der Seite, die der Hauptplatine (3) zugewandt ist, die oben erwähnten Leistungskomponenten oder-vorrichtungen (6a) wie auch Leitungsanschlüsse (12) aufnimmt, die mit entsprechenden Leitungsanschlüssen (11) der Hauptplatine (3) mit Hilfe von Federelementen (10) verbunden sind, die aus einem Metallmaterial bestehen.

4. Elektronische Steuereinheit nach Anspruch 1 oder 2, bei der die Trägerplatte (6) des Zwischenaufbaus eine Platte ist, die aus einem dielektrischen Material, vorzugsweise Aluminium, besteht, auf deren einer Seite auf zwei gegenüberliegenden Flanken erste Enden (110a) entsprechender Verbindungsanschlüsse (110) befestigt sind, die aus einem Metallmaterial bestehen und in einer allgemeinen Konfiguration, im wesentlichen in Gestalt eines S, nach innen gekrümmt sind; wobei die anderen oder zweiten Enden (110b) der Verbindungsanschlüsse (110) mit den Verbindungsanschlüssen (11) der Hauptplatine (3) in einem federnd vorgespannten Zustand verschweißt sind.

5. Elektronische Steuereinheit nach Anspruch 2, bei der die mechanischen und elektrischen Verbindungseinrichtungen enthalten:
eine Platte (8), die aus einem thermisch leitfähigen Material, vorzugsweise Kupfer oder Legierungen daraus, besteht und in Kontakt mit der Seite der Trägerplatte (6) des Zwischenaufbaus (5) angeordnet ist, die in die entgegengesetzte Richtung zur Hauptplatine (3) weist; und
eine Schicht eines thermisch leitfähigen Gels (9) das eine Phasenübergangstemperatur im Bereich der zu erwartenden Arbeitstemperatur der Bodenplatte oder - wand (2a) hat, wobei die Schicht des Gels (9) zwischen der oben erwähnten Leiterplatte (8) und der Bodenplatte oder -wand (2a) angeordnet ist.

6. Elektronische Steuereinheit nach Anspruch 3 und 5, bei der eine dünne Schicht (7) eines elektrisch und thermisch isolierenden Materials zwischen der Druckschaltkartenträgerplatte (6) und der oben erwähnten wärmeleitenden Platte (8) angeordnet ist.

## Revendications

1. Unité de commande électronique (1), en particulier pour des véhicules à moteur, comprenant :
- un contenant (2) réalisé en un matériau métallique, comportant une plaque ou paroi de base (2a) capable d'agir en tant que dissipateur de chaleur ;
- une carte mère de circuit imprimé (3), montée face à ladite plaque ou paroi de base (2a) et à une distance prédéfinie de celle-ci et logeant une pluralité de composants ou dispositifs électriques/électroniques (4a) de l'unité de commande ;
- une structure de support de charge intermédiaire (5) comprenant une plaque de support (6) agencée entre la carte mère (3) et ladite plaque ou paroi de base (2a) et logeant un ou plusieurs composants ou dispositifs électroniques de puissance (6a) de ladite unité de commande ; et
- des moyens d'accouplement mécanique et de couplage électrique (10 ; 110) agencés entre ladite plaque de support (6) de la structure intermédiaire (5) et la carte mère (3) et comprenant des éléments électriquement conducteurs et mécaniquement élastiques (10 ; 110), capables d'agir en tant qu'éléments réalisant une connexion électrique entre les dispositifs (4a) de la carte mère (3) et les dispositifs (6a) de la structure intermédiaire (5), et en tant qu'éléments à ressort tendant à pousser ladite structure intermédiaire (5) vers la plaque ou paroi de base (2a).

2. Unité de commande électronique selon la revendication 1, comprenant également des moyens de couplage thermique et d'accouplement mécanique (8, 9) agencés entre la plaque de support (6) de la structure intermédiaire (5) et la plaque ou paroi de base (2a).

3. Unité de commande électronique selon la revendication 1 ou 2, dans laquelle la plaque de support (6) de la structure intermédiaire (5) est une plaque avec des circuits imprimés qui, du côté faisant face à la carte mère (3), loge les composants ou dispositifs de puissance (6a) susmentionnés ainsi que des bornes conductrices (12) connectées à des bornes conductrices (11) correspondantes de la carte mère (3) au moyen d'éléments à ressort (10) réalisés en un matériau métallique.

4. Unité de commande électronique selon la revendication 1 ou 2, dans laquelle la plaque de support (6) de la structure intermédiaire est une plaque qui est réalisée en un matériau diélectrique, de préférence de l'alumine, à un côté de laquelle, sur deux flancs opposés, des premières extrémités (110a) de bornes de connexion (110) respectives réalisées en un matériau métalliques et incurvées vers l'intérieur en une configuration générale essentiellement sous la forme d'un S sont fixées ; les autres extrémités ou deuxièmes extrémités (110b) desdites bornes de connexion (110) étant soudées à des bornes de connexion (11) de la carte mère (3) dans une condition de sollicitation par ressort.

5. Unité électronique selon la revendication 2, dans laquelle lesdits moyens d'accouplement mécanique et de couplage électrique comprennent :
une plaque (8) qui est réalisée en un matériau thermiquement conducteur, de préférence du cuivre ou des alliages de celui-ci, et qui est agencée en contact avec le côté de la plaque de support (6) de la structure intermédiaire (5) orienté dans la direction opposée à la carte mère (3) ; et
une couche de gel thermiquement conducteur (9) ayant une température de transition de phase dans la région de la température de fonctionnement envisagée de ladite plaque ou paroi de base (2a), ladite couche de gel (9) étant agencée entre la plaque conductrice (8) susmentionnée et la plaque ou partie de base (2a).

6. Unité de commande électronique selon les revendications 3 et 5, dans laquelle une mince couche (7) de matériau électriquement et thermiquement isolant est agencée entre ladite plaque de support de circuit imprimé (6) et la plaque thermiquement conductrice (8) susmentionnée.
